# EUROPÄISCHE PATENTANMELDUNG

(11) **EP 3 813 102 A1**
(43) Veröffentlichungstag der Anmeldung: **28.04.2021**
(21) Anmeldenummer: 20203499.7
(22) Anmeldetag: 23.10.2020
(51) Int. Cl.: H01L 21/8234, H01L 27/02, H01L 27/088, H01L 21/8252, H01L 27/06, H01L 27/085, H03F 3/193

(54) **INTEGRIERTER SCHALTKREIS**

(30) Priorität: 24.10.2019 DE 102019216400; 03.03.2020 DE 102020202683
(71) Anmelder: FRAUNHOFER-GESELLSCHAFT zur Förderung der angewandten Forschung e.V., 80686 München (DE)
(72) Erfinder: Cwiklinski, Maciej, 79108 Freiburg (DE)
(74) Vertreter: Friese Goeden Patentanwälte PartGmbB

(57) **Zusammenfassung**

Die Erfindung betrifft einen integrierten Schaltkreis (35) mit zumindest einem ersten Feldeffekttransistor (1), welcher zumindest einen ersten Sourcekontakt (12) und zumindest einen ersten Drainkontakt (11) und zumindest einen ersten Gatekontakt (13) aufweist und mit zumindest einem zweiten Feldeffekttransistor (2), welcher zumindest einen zweiten Sourcekontakt (22) und zumindest einen zweiten Drainkontakt (21) und zumindest einen zweiten Gatekontakt (23) aufweist, wobei der erste Drainkontakt (11) mit dem zweiten Drainkontakt (21) verbunden ist und der erste Sourcekontakt (12) mit dem zweiten Gatekontakt (23) verbunden ist, wobei der erste Sourcekontakt (12), der erste Drainkontakt (11), der erste Gatekontakt (13), der zweite Sourcekontakt (22), der zweite Drainkontakt (21) und der zweite Gatekontakt (23) als strukturierte Metallisierung auf einem Substrat (5) ausgebildet sind und der erste und zweite Drainkontakt (11, 21) den selben Flächenbereich (51) auf dem Substrat (5) belegen.

## Beschreibung

Die Erfindung betrifft einen integrierten Schaltkreis mit zumindest einem ersten Feldeffekttransistor, welcher zumindest einen ersten Sourcekontakt und zumindest einen ersten Drainkontakt und zumindest einen ersten Gatekontakt aufweist und mit zumindest einem zweiten Feldeffekttransistor, welcher zumindest einen zweiten Sourcekontakt und zumindest einen zweiten Drainkontakt und zumindest einen zweiten Gatekontakt aufweist, wobei der erste Drainkontakt mit dem zweiten Drainkontakt verbunden ist und der erste Sourcekontakt mit dem zweiten Gatekontakt verbunden ist. Schaltkreise dieser Art werden als f_{T}-Doubler bezeichnet und dienen vornehmlich als Hochfrequenzverstärker.

Aus K. Krishnamurthy, R. Vetury, S. Keller, U. Mishra, M.J.W. Rodwell, S.I. Long: "Broadband GaAs MESFET and GaN HEMT resistive feedback power amplifiers", IEEE Journal of Solid-State Circuits, Vol. 35, No. 9, September 2000 ist ein Schaltkreis der eingangs genannten Art bekannt. Dieser Schaltkreis erreichte eine Verstärkung von 11 dB bei einer Bandbreite von 0,2 bis 7,5 GHz. Jedoch besteht ein Bedürfnis, für Anwendungen im Bereich der Radartechnik oder der Datenübertragung Verstärker mit wesentlich höherer Arbeitsfrequenz bereitzustellen.

Ausgehend vom Stand der Technik liegt der Erfindung somit die Aufgabe zugrunde, einen Verstärker mit höherer Arbeitsfrequenz bereitzustellen.

Die Aufgabe wird erfindungsgemäß durch einen integrierten Schaltkreis gemäß Anspruch 1 gelöst. Vorteilhafte Weiterbildungen der Erfindung finden sich in den Unteransprüchen.

Erfindungsgemäß wird ein integrierter Schaltkreis mit zumindest einem ersten Feldeffekttransistor und zumindest einem zweiten Feldeffekttransistor vorgeschlagen. Jeder Feldeffekttransistor enthält zumindest einen Sourcekontakt, zumindest einen Drainkontakt und zumindest einen Gate-kontakt. Erfindungsgemäß wird vorgeschlagen, die beiden Drainkontakte miteinander zu verbinden und als Ausgang des Verstärkers zu verwenden. Weiterhin wird der Sourcekontakt des zweiten Feldeffekttransistors mit einem Referenzpotenzial verbunden, beispielsweise einem Massepotenzial. Der Sourcekontakt des ersten Feldeffekttransistors ist mit dem Gatekontakt des zweiten Feldeffekttransistors verbunden. Der Gatekontakt des ersten Feldeffekttransistors stellt den Eingang des Verstärkers dar. Eine solche Schaltung kann als f_{T}-Doppler-Schaltung bezeichnet werden.

Um die Bandbreite bzw. die Grenzfrequenz des integrierten Schaltkreises über die aus dem Stand der Technik bekannte Grenze hinaus anzuheben, wird erfindungsgemäß vorgeschlagen, die Source-, Drain- und Gatekontakte der ersten und zweiten Feldeffekttransistoren als strukturierte Metallisierung auf einem Substrat auszubilden und dabei für den ersten und zweiten Drainkontakt denselben Flächenbereich auf dem Substrat zu verwenden. Dieses Merkmal hat die Wirkung, dass Verbindungsleitungen zwischen den Drainkontakten entfallen können. Hierdurch können parasitäre Induktivitäten bzw. Kapazitäten reduziert und die Grenzfrequenz erhöht werden. Darüber hinaus reduziert die erfindungsgemäße Anordnung der Kontakte den Flächenbedarf bzw. "Footprint" des integrierten Schaltkreises auf dem Substrat. Hierdurch kann der Verbrauch an Halbleitermaterial reduziert sein, sodass auf einer vorgegebenen Fläche eines Wafers eine größere Anzahl von Schaltkreisen hergestellt werden kann.

Der als Drainkontakt beider Feldeffekttransistoren verwendete Flächenbereich der Metallisierung kann in einigen Ausführungsformen der Erfindung polygonal oder rund sein. In einigen Ausführungsformen der Erfindung kann der Flächenbereich viereckig, insbesondere rechteckig sein.

In einigen Ausführungsformen der Erfindung kann unter dem Flächenbereich der Metallisierung eine aktive Zone im Substrat ausgebildet werden. Eine solche aktive Zone kann beispielsweise ein ohmscher Kontakt zum darunterliegenden Material sein.

In einigen Ausführungsformen der Erfindung kann der integrierte Schaltkreis weiterhin einen Gleichstrompfad enthalten, über welchen die Gateladung des zweiten Feldeffekttransistors zu einem Referenzpotential abfließen kann, wenn der erste Feldeffekttransistor sperrt. Da der Gatekontakt nahezu stromlos ist, wird hierdurch sichergestellt, dass der Schaltzustand beider Feldeffekttransistoren im Wesentlichen gleichlaufend ist.

In einigen Ausführungsformen der Erfindung kann der erste und zweite Drainkontakt durch zwei Flächenbereiche der Metallisierung gebildet werden, welche auf der Oberfläche des Substrates angeordnet sind und welche sich an gegenüberliegenden Seiten des ersten Sourcekontaktes des ersten Feldeffekttransistors befinden. Hierdurch kann die für die Drainkontakte zur Verfügung stehende Fläche vergrößert sein, sodass die Stromtragfähigkeit erhöht und/oder die Verlustleistung reduziert sein kann. Hierdurch kann die Ausgangsleistung des integrierten Schaltkreises vergrößert sein.

In einigen Ausführungsformen der Erfindung kann an der dem ersten Sourcekontakt abgewandten Seite der ersten und zweiten Drainkontakte jeweils ein zweiter Sourcekontakt angeordnet sein. Da der integrierte Schaltkreis einen ähnlichen Aufbau aufweist wie ein bipolarer Darlington-Transistor, stellt der zweite Feldeffekttransistor einen größeren Teil der Ausgangsleistung zur Verfügung. Durch die Vergrößerung der Fläche der zweiten Sourcekontakte wird somit die Stromtragfähigkeit bzw. die Leistung erhöht. Der Aufbau hat darüber hinaus die Wirkung, dass die zweiten Sourcekontakte in zumindest einer Raumrichtung innerhalb der durch das Substrat definierten Ebene den integrierten Schaltkreis begrenzen, sodass alle anderen Elemente innerhalb der so definierten Zone angeordnet sind. Da die zweiten Sourcekontakte auf einem Referenzpotenzial liegen, beispielsweise einem Massepotenzial, können diese somit auch der Abschirmung hochfrequenter Störungen dienen. Darüber hinaus wird die Integration koplanarer Wellenleiter erleichtert.

In einigen Ausführungsformen der Erfindung kann der Gleichstrompfad zumindest einen Widerstand und/oder zumindest eine Induktivität enthalten bzw. daraus bestehen. Sofern ein Widerstand und eine Induktivität vorhanden sind, können diese in einigen Ausführungsformen der Erfindung seriell miteinander verschaltet sein. Hierdurch kann das Abfließen hochfrequenter Ströme über den Gleichstrompfad reduziert sein, sodass der Gatekontakt des zweiten Feldeffekttransistors rascher umgeladen werden kann. Hierdurch kann die Grenzfrequenz des integrierten Schaltkreises weiter ansteigen.

In einigen Ausführungsformen der Erfindung kann der integrierte Schaltkreis eine Kapazität enthalten, welche zwischen dem ersten Sourcekontakt und dem zweiten Gatekontakt angeordnet ist. Hierdurch kann eine Vorspannung an den zweiten Gatekontakt angelegt werden, sodass sich dieser auf einem anderen elektrischen Potenzial befindet als der erste Sourcekontakt.

In einigen Ausführungsformen der Erfindung kann die Anzahl und/oder die Fläche der Flächenbereiche der zweiten Drainkontakte und/oder der zweiten Sourcekontakte unterschiedlich, insbesondere größer sein als die Anzahl und/oder die Fläche des ersten und zweiten Drainkontakts und/oder des ersten Sourcekontakts und des zweiten Gatekontakts. Dies ermöglicht es, über den zweiten Feldeffekttransistor eine höhere Leistung bereitzustellen als über den ersten Feldeffekttransistor, sodass die Ausgangsleistung des integrierten Schaltkreises insgesamt erhöht sein kann. In dieser Schaltung sind die parasitären Eingangskapazitäten, d.h. die Gate-Source-Kapazität beider FETs in Reihe geschaltet, so dass die kleinere Kapazität die dominierende ist. Beim Verbinden eines kleineren ersten FET mit einem größeren zweiten FET wird daher die effektive Eingangskapazität der Struktur durch den kleineren Wert dominiert. Daher kann man eine relativ große Struktur mit hoher Ausgangsleistung mit einer niedrigen Eingangskapazität ansteuern, was für den Hochfrequenzbetrieb mit hohen Bandbreiten von Vorteil ist.

In einigen Ausführungsformen der Erfindung kann das Substrat ein Halbleitersubstrat sein oder einen Halbleiter enthalten. In einigen Ausführungsformen kann das Substrat zumindest ein Gruppe-III-Nitrid enthalten oder daraus bestehen. Ein solches Gruppe-III-Nitrid enthält zumindest ein Element der dritten Hauptgruppe des Periodensystems und Stickstoff. Das Gruppe-III-Nitrid kann ausgewählt sein aus einer binären, ternären oder quaternären Verbindung. Beispielsweise kann das Gruppe-III-Nitrid ausgewählt sein aus GaN, AlN, AlGaN, InGaN, InAlN, InGaN oder weiteren, hier nicht genannten Verbindungen.

In einigen Ausführungsformen der Erfindung kann das Substrat eine Mehrzahl von Einzelschichten unterschiedlicher Gruppe-III-Nitride enthalten bzw. daraus bestehen. Die Mehrzahl von Schichten kann eine Halbleiterheterostruktur bilden. In einigen Ausführungsformen der Erfindung kann sich in der Halbleiterheterostruktur an zumindest einer Schichtgrenze ein zweidimensionales Elektronengas ausbilden. Hierdurch kann die Ladungsträgerbeweglichkeit erhöht sein, sodass die Grenzfrequenz und/oder die elektrische Ausgangsleistung vergrößert sein kann. Eine solche Mehrzahl von Einzelschichten kann auf Silizium und/oder Al₂O₃ und/oder SiC abgeschieden sein.

In einigen Ausführungsformen der Erfindung kann das Substrat ein Halbleitersubstrat sein oder einen Halbleiter enthalten, welches einen III-V-Verbindungshalbleiter oder einen Halbleiter der Gruppe IV oder einen II-VI-Verbindungshalbleiter enthält oder daraus besteht. Ein solches Halbleitersubstrat kann lateral und/oder vertikal strukturiert sein bzw. Raumbereiche aufweisen, welche unterschiedliche Dotierstoffe und/oder Dotierstoffkonzentration aufweisen.

In einigen Ausführungsformen der Erfindung kann der integrierte Schaltkreis eine Grenzfrequenz von mehr als 20 GHz oder mehr als 40 GHz oder mehr als 60 GHz oder mehr als 100 GHz aufweisen. Die Grenzfrequenz ist dabei diejenige Frequenz, bei welcher die Stromverstärkung des integrierten Schaltkreises 1 ist, wenn ein Sinussignal an den Eingang angelegt wird und der Ausgang kurzgeschlossen ist.

In einigen Ausführungsformen der Erfindung kann der integrierte Schaltkreis eine Grenzfrequenz aufweisen, welche um mehr als 10% oder mehr als 20% oder mehr als 30% höher ist als die Grenzfrequenz eines einzelnen FET in einer Common-Source-Topologie, wobei der selbe Herstellungsprozess verwendet wird.

In einigen Ausführungsformen der Erfindung kann der integrierte Schaltkreis zusätzlich zu dem zumindest einen ersten Feldeffekttransistor und zumindest einen zweiten Feldeffekttransistor (f_{T}-Doppler) weitere Bauelemente enthalten. Beispielsweise können weitere Feldeffekttransistoren bzw. Verstärkerstufen hinzugefügt werden (f_{T}-Tripler) und/oder ein Common-Gate (CG) FET. Eine solche Konfiguration kann als Cascodenschaltung bezeichnet werden. In weiteren Ausführungsformen der Erfindung kann der erste Gate-Kontakt des ersten Feldeffekttransistors mit dem Ausgang eines Common-Drain (CD) Feldeffekttransistors verbunden sein. Schließlich kann die erfindungsgemäß vorgeschlagene Grundschaltung mehrfach vorhanden sein, wobei die einzelnen f_{T}-Doppler-Schaltungen seriell und/oder parallel miteinander verbunden sein können. Der erfindungsgemäße integrierte Schaltkreis kann in elektronischen Geräten eingesetzt werden, beispielsweise in einem Verstärker, einem Messgerät, einem Empfänger, einem Sender oder einem ähnlichen Gerät. Ein solches elektronisches Gerät kann Anwendung finden im Mobilfunk, in der Radartechnik, in der Nachrichtentechnik oder ähnlichen Anwendungen.

Nachfolgend soll die Erfindung anhand von Figuren ohne Beschränkung des allgemeinen Erfindungsgedankens näher erläutert werden. Dabei zeigt:
- Figur 1: ein Schaltbild des integrierten Schaltkreises gemäß der ersten und zweiten Ausführungsform.
- Figur 2: zeigt eine Aufsicht auf einen erfindungsgemäßen Schaltkreis gemäß einer ersten Ausführungsform.
- Figur 3: zeigt den Schnitt A-A des erfindungsgemäßen Schaltkreises.
- Figur 4: zeigt den Schnitt B-B des erfindungsgemäßen Schaltkreises.
- Figur 5: zeigt den Schnitt C-C des erfindungsgemäßen Schaltkreises.
- Figur 6: zeigt den Schnitt D-D des erfindungsgemäßen Schaltkreises.
- Figur 7: zeigt den Schnitt E-E des erfindungsgemäßen Schaltkreises.
- Figur 8: zeigt den Schnitt F-F des erfindungsgemäßen Schaltkreises.
- Figur 9: zeigt eine Aufsicht auf einen erfindungsgemäßen Schaltkreis gemäß einer zweiten Ausführungsform.
- Figur 10: zeigt die Aufsicht auf einen erfindungsgemäßen Schaltkreis gemäß einer dritten Ausführungsform.
- Figur 11: zeigt die Aufsicht auf einen erfindungsgemäßen Schaltkreis gemäß einer vierten Ausführungsform.
- Figur 12: zeigt die Aufsicht auf einen erfindungsgemäßen Schaltkreis gemäß einer fünften Ausführungsform.
- Figur 13: zeigt die maximale stabile Verstärkung (MSG) und die maximale verfügbare Verstärkung (MAG) über der Frequenz.
- Figur 14: zeigt die Stromverstärkung über der Frequenz.
- Figur 15: zeigt das Kleinsignalverhalten über der Frequenz eines erfindungsgemäßen Schaltkreis gemäß der dritten Ausführungsform.
- Figur 16: zeigt das Großsignalverhalten über der Frequenz eines erfindungsgemäßen Schaltkreis gemäß der dritten Ausführungsform.
- Figur 17: zeigt ein Schaltbild des integrierten Schaltkreises einer sechsten Ausführungsform.
- Figur 18: zeigt die Aufsicht auf einen erfindungsgemäßen Schaltkreis gemäß der sechsten Ausführungsform.
- Figur 19: ein Schaltbild des integrierten Schaltkreises gemäß der dritten und vierten Ausführungsform.

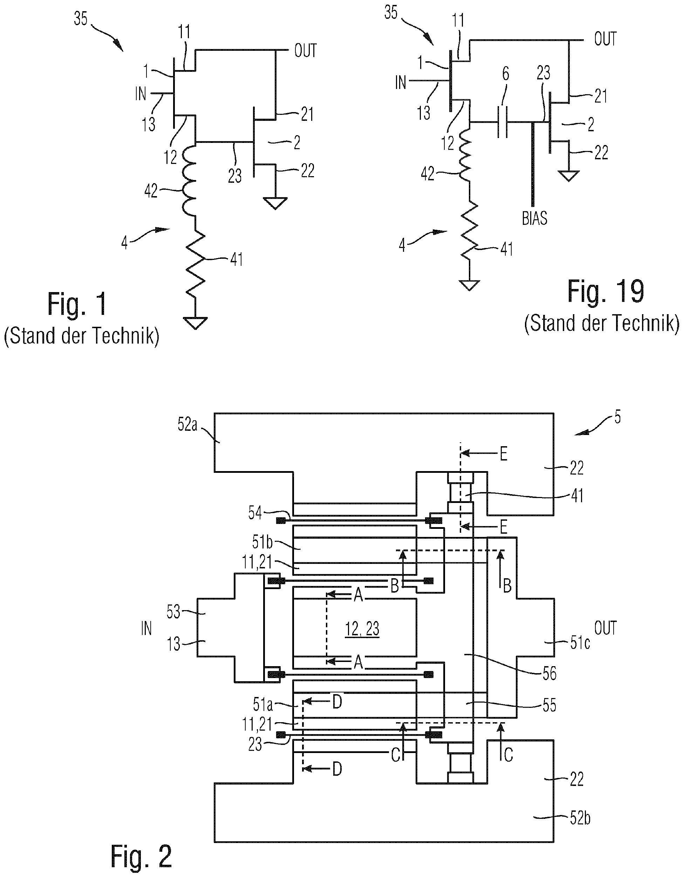

Figur 1 zeigt ein Schaltbild des integrierten Schaltkreises gemäß der ersten bis fünften Ausführungsform. Der Schaltkreis enthält zumindest einen ersten Feldeffekttransistor 1 und einen zweiten Feldeffekttransistor 2. Der erste Feldeffekttransistor 1 weist einen ersten Drainkontakt 11 sowie einen ersten Sourcekontakt 12 auf. Zwischen Source und Drain befindet sich ein Kanal, dessen Leitfähigkeit in Abhängigkeit einer Gatespannung kontrolliert werden kann, welche am ersten Gatekontakt 13 angelegt werden kann.

Der zweite Feldeffekttransistor 2 weist einen zweiten Drainkontakt 21 sowie einen zweiten Sourcekontakt 22 auf. Weiterhin weist der zweite Feldeffekttransistor 2 in an sich bekannter Weise einen zweiten Gatekontakt 23 auf.

Der zweite Sourcekontakt 22 ist mit einem Referenzpotenzial verbunden, beispielsweise einem Erdpotenzial bzw. einem Massepotenzial. Der zweite Gatekontakt 23 ist mit dem ersten Sourcekontakt 12 verbunden. Der erste Gatekontakt 13 bildet den Eingang der Verstärkerschaltung 35. Die beiden Drainkontakte 11 und 21 bilden den Ausgang der Verstärkerschaltung. Bei Anlegen einer Eingangsspannung an den ersten Gatekontakt 13 wird der Kanal zwischen dem ersten Sourcekontakt 12 und dem ersten Drainkontakt 11 leitend, sodass eine Gatespannung am zweiten Gatekontakt 23 anliegt, welche den Kanal zwischen dem zweiten Sourcekontakt 22 und dem zweiten Drainkontakt 21 ebenfalls leitfähig schaltet.

Beim Schalten der Gatespannung unter die Schaltschwelle am ersten Gatekontakt 13 sperrt der Kanal zwischen dem ersten Sourcekontakt 12 und dem ersten Drainkontakt 11. Da der zweite Gatekontakt 23 im Wesentlichen stromlos ist, wird die dort gesammelte Ladung über den Gleichstrompfad 4 abgeleitet. Um zu vermeiden, dass ein hochfrequentes Nutzsignal über den Gleichstrompfad 4 zum Massepotenzial kurzgeschlossen wird, kann der Gleichstrompfad 4 zumindest einen Widerstand 41 und/oder zumindest eine Induktivität 42 enthalten. Das in Figur 1 gezeigte Grundelement wird in der vorliegenden Beschreibung als f_{T}-Doppler-Schaltung bezeichnet. Diese kann in einigen Ausführungen der Erfindung mehrfach vorhanden sein, wobei die einzelnen f_{T}-Doppler-Schaltungen seriell und/oder parallel miteinander verbunden sein können. In anderen Ausführungsformen kann zumindest eine f_{T}-Doppler-Schaltung mit weiteren Schaltungselementen verbunden sein, beispielsweise Darlington-Transistoren und/oder zumindest einem Feldeffekttransistor in Common-Source und/oder Common-Drain und/oder Common-Gate-Topologie.

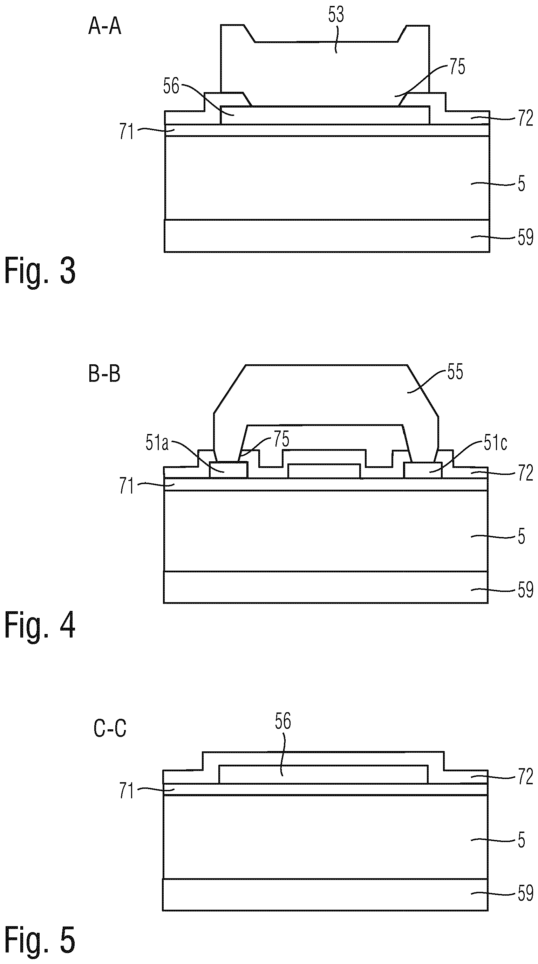

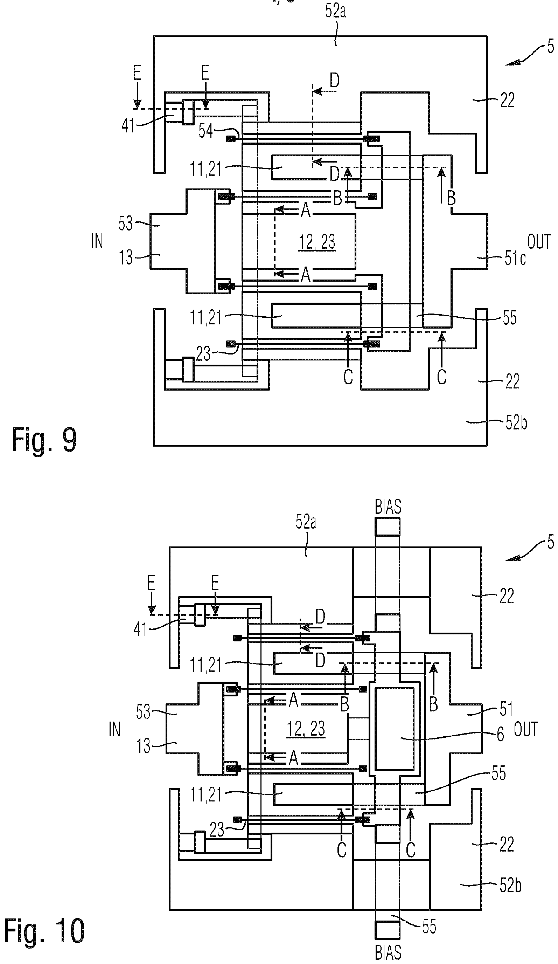

Figur 2 zeigt ein erstes Ausführungsbeispiel der erfindungsgemäßen Umsetzung der anhand von Figur 1 dargestellten Schaltung in einen integrierten Schaltkreis. Dargestellt ist eine Aufsicht auf die Oberfläche eines Substrates 5. Dabei sind in Figur 2 eine Mehrzahl von Metallisierungen erkennbar, welche die Grundstruktur des integrierten Schaltkreises definieren. Die Figuren 3 bis 8 zeigen verschiedene Schnitte durch das Halbleiterbauelement, deren Lage in Figur 2 und teilweise auch in den weitere Ausführungsbeispiele zeigenden Figuren 9 bis 12 dargestellt ist.

Wie aus Figur 2 ersichtlich ist, weist der zweite Sourcekontakt 22 zwei Flächenbereiche 52a und 52b auf, welche die äußerste Begrenzung des planar strukturierten Bauelementes definieren. Daran angrenzend befinden sich zwei Flächenbereiche 51a und 51b, welche jeweils sowohl als erster Drainkontakt 11 als auch als zweiter Drainkontakt 21 dienen. Hierdurch können Verbindungsleitungen zwischen den Drainkontakten eingespart werden, sodass die damit verbundenen parasitären Induktivitäten und Kapazitäten entfallen. Die Flächenbereiche 51a und 51b sind mit einem optionalen dritten Flächenbereich 51c über Brückenkontakte 55 verbunden, um so einen einzigen Ausgangskontakt des Verstärkers bereitzustellen.

Die Flächenbereiche 51b und 51a schließen einen Flächenbereich 54 ein, welcher wiederum eine Doppelfunktion als erster Sourcekontakt 12 und zweiter Gatekontakt 54 einnimmt. Hierdurch können Verbindungsleitungen zwischen dem ersten Sourcekontakt 12 und dem zweiten Gatekontakt 23 reduziert sein.

Die Metallisierungen sind teilweise in größerer Schichtdicke ausgeführt, welche beispielsweise durch Galvanisieren erhalten werden kann, wie anhand des Schnittes A-A in Figur 3 näher erläutert wird. Beispielhaft ist eine solche Metallisierung am ersten Sourcekontakt 12 ausgeführt. Eine solche Metallisierung kann eine Dicke von etwa 200 nm bis etwa 3 µm aufweisen.

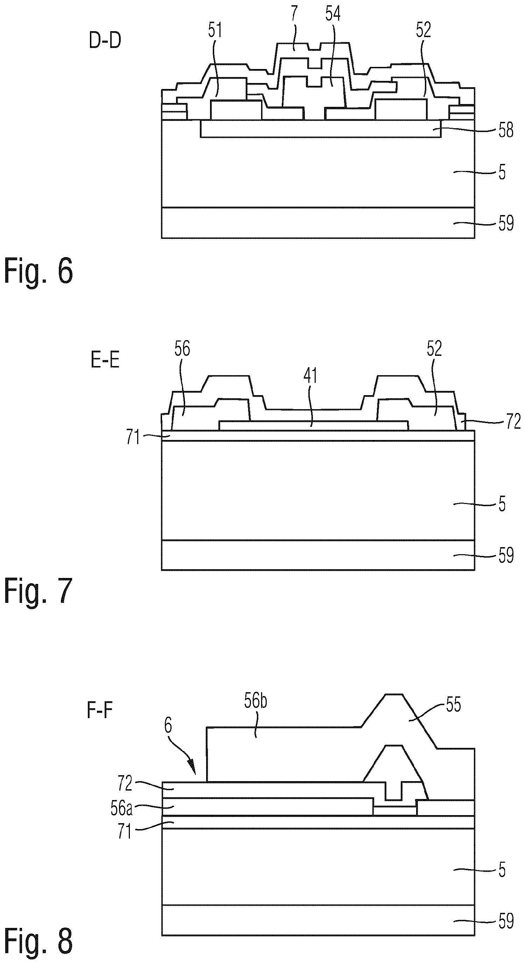

Teilweise sind die Metallisierungen des integrierten Schaltkreises 5 in geringerer Schichtdicke ausgeführt, welche beispielsweise durch Sputtern oder Aufdampfen erhalten werden kann, wie anhand des Schnittes C-C in Figur 5 näher erläutert wird. Teilweise müssen elektrische Signale in unterschiedlichen Ebenen geführt werden. Dies gelingt über Brückenkontakte, welche im Schnitt B-B in Figur 4 dargestellt sind. Ein Gatekontakt ist in Figur 6 näher erläutert, welche den Schnitt D-D zeigt. Figur 7 erläutert anhand des Schnittes entlang der Linie E-E den Aufbau eines Widerstandes 41 im Gleichstrompfad 4.

Anhand der Figur 3 wird die Ausführung eines metallisierten Flächenbereiches 53 näher erläutert. Figur 3 zeigt ein Substrat 5, welches beispielsweise Al₂O₃ und/oder SiC und/oder Si und/oder ein Gruppe-III-Nitrid enthalten kann. Das Gruppe-III-Nitrid enthält eine binäre, ternäre oder quaternäre Verbindung aus zumindest einem Element der dritten Hauptgruppe des Periodensystems und Stickstoff. Das Substrat 5 kann einen mehrschichtigen Aufbau aufweisen und beispielsweise als Halbleiterheterostruktur ausgeführt sein oder eine solche enthalten, welche mittels MBE, MOVPE, MOCVD oder anderen, an sich bekannten Verfahren hergestellt worden ist.

Das Substrat 5 weist eine Unterseite auf, welche mit einer optionalen Metallisierung 59 versehen sein kann. Diese kann zur elektrischen Kontaktierung des Substrates 5 dienen und beispielsweise mit einem Referenzpotenzial verbindbar sein.

Die in Figur 2 sichtbare Oberseite des Substrates 5 kann mit einem ersten Dielektrikum 71 versehen sein, welches beispielsweise ein Siliziumnitrid, ein Siliziumoxid, ein Siliziumoxinitrid, ein Polymer oder Benzocyclobuten enthält oder daraus besteht. Das erste Dielektrikum 71 kann eine Schichtdicke von etwa 5 nm bis etwa 20 nm oder von etwa 20 nm bis etwa 300 nm aufweisen.

Auf dem ersten Dielektrikum 71 ist eine strukturierte Metallisierung 56 als Dünnschicht angeordnet, welche beispielsweise eine Dicke von etwa 2 nm bis etwa 20 nm oder von etwa 5 nm bis etwa 25 nm oder von etwa 25 nm bis etwa 1000 nm oder von etwa 250 nm bis etwa 600 nm aufweisen kann. Wie Figur 5 zeigt, kann diese Dünnschichtmetallisierung bereits ausreichen, um in Teilflächen mit geringer Strombelastung elektrische Felder innerhalb des Substrates 5 zu erzeugen und hierdurch die Ladungsträgerdichte in aktiven Halbleiterschichten zu beeinflussen oder elektrische Signale innerhalb der durch das Substrat 5 definierten Ebene zu leiten.

Wie Figur 3 und Figur 5 weiter zeigen, kann die Dünnschichtmetallisierung 56 mit einem optionalen zweiten Dielektrikum 72 versehen werden, welches als Passivierungsschicht die Oxidation der Dünnschichtmetallisierung 56 verhindert. Auch das zweite Dielektrikum 72 kann ein Nitrid enthalten oder daraus bestehen, beispielsweise Siliziumnitrid. Alternativ oder zusätzlich kann auch das zweite Dielektrikum 72 Siliziumoxid, Siliziumoxinitrid, ein Polymer und/oder Benzocyclobuten enthalten oder daraus bestehen.

Figur 3 zeigt die Verstärkung der Dünnschichtmetallisierung 56, um auf diese Weise den Leiterquerschnitt zu erhöhen und eine höhere Strombelastbarkeit zu ermöglichen. Hierzu wird das zweite Dielektrikum 72 teilweise entfernt, um eine Öffnung 75 zu erzeugen. Die Entfernung des Dielektrikums kann beispielsweise durch nass- oder trockenchemisches Ätzen erfolgen. Daraufhin wird eine Dickschichtmetallisierung 53 abgeschieden, beispielsweise durch ein Sputterverfahren, thermisches Aufdampfen und/oder galvanische oder außenstromlose Abscheidung. Auch die Dickschichtmetallisierung 53 kann entweder durch nachfolgendes Strukturieren und Ätzen in die in Figur 2 gezeigte Form gebracht werden oder aber durch vorheriges Maskieren nur in Teilflächen abgeschieden werden. Die Gesamtdicke kann zwischen etwa 200 nm und etwa 30 µm betragen.

Figur 4 zeigt entlang der Schnittlinie B-B die beispielhafte Ausführung eines Brückenkontaktes. Gleiche Bestandteile der Erfindung sind mit gleichen Bezugszeichen versehen, sodass sich die nachfolgende Beschreibung auf die wesentlichen Unterschiede beschränkt. Wie in Figur 4 ersichtlich ist, beginnt und endet der Brückenkontakt 55 auf einer Dünnschichtmetallisierung 51a und 51c, welche wiederum auf einem ersten Dielektrikum 71 abgeschieden ist und mit einem zweiten Dielektrikum 72 abgedeckt ist. Das zweite Dielektrikum 72 ist teilweise mit Öffnungen 75 versehen, um die Oberfläche der Dünnschichtmetallisierung 51a und 51c freizulegen. Der Brückenkontakt 55 erstreckt sich von der ersten Dünnschichtmetallisierung 51a zur zweiten Dünnschichtmetallisierung 51c, ohne dabei das zweite Dielektrikum 72 zu berühren, sodass weitere Metallisierungen bzw. Signalebenen unterhalb des Brückenkontaktes 55 geführt werden können.

Anhand der Figur 6 wird die Ausführung eines Gatekontaktes 54 gezeigt. Wie Figur 6 zeigt, befindet sich innerhalb des Substrates 5 eine Halbleiterheterostruktur 58, welche in einigen Ausführungsformen der Erfindung dazu eingerichtet ist, ein zweidimensionales Elektronengas auszubilden. Die Halbleiterheterostruktur 58 wird von metallischen Leitern 51 und 52 kontaktiert. Die metallischen Kontakte 51 und 52 können ohmsche Kontakte zur Halbleiterheterostruktur 58 ausbilden. Zum Schutz vor Oxidation können die metallischen Kontakte mit einer oder mehreren dielektrischen Schichten 7 abgedeckt sein. Die metallischen Kontakte 51 und 52 können beispielsweise Source- und Drainkontakte 11, 21, 22, 23 eines Feldeffekttransistors bilden.

Zwischen den Source- und Drainkontakten ist ein Gatefinger 54 angeordnet, welcher in Figur 2 in der Aufsicht und in Figur 6 im Schnitt dargestellt ist. Der Gatefinger 54 kann auf einer Halbleiterheterostruktur 58 aufgebracht sein, sodass bei Anlegen einer Spannung an dem Gatefinger 54 ein elektrisches Feld auf die Halbleiterheterostruktur 58 einwirkt, welches eine Bandverbiegung induziert und dadurch die Ausbildung eines zweidimensionalen Elektronengases (2DEG) und dadurch die elektrische Leitfähigkeit beeinflusst. Die Halbleiterheterostruktur 58 enthät eine Mehrzahl von Epitaxieschichten, welche Teil eines Transistors mit hoher Elektronenmobilität (HEMT) ist. In einer anderen Ausführungsform kann der Gatefinger 54 direkt auf einer Halbleiteroberfläche angeordnet sein und einen Schottky-Kontakt bilden, so dass ein Metall-Halbleiter-FET (MESFET) entsteht. In wiederum anderen Ausführungsformen der Erfindung kann der Gatefinger 54 vom Halbleiter durch einen optionalen Isolator getrennt sein, der sich auf der Oberseite des Halbleitersubstrates befindet (MOSFET). Bei Anlegen einer Gatespannung wirkt ein elektrisches Feld auf die Halbleiterstruktur ein, welches eine Bandverbiegung induziert und dadurch die elektrische Leitfähigkeit beeinflusst. Jedoch verhindert die unterhalb des Gatefingers 54 liegende Sperrschicht einen elektrischen Stromfluss. In weiteren Ausführungsformen der Erfindung können MOSFET- und HEMT zu einem MOSHEMT kombiniert werden.

Um die Langzeitstabilität zu erhöhen, kann der Gatefinger 54 unterhalb weiterer optionaler dielektrischer Schichten 7 angeordnet werden.

Das anhand von Figur 6 beispielhaft im Falle eines MESFET- bzw. HEMT-Transistors beschriebene Prinzip kann leicht auf alternative Ausführungsformen übertragen werden, beispielsweise einen MOSHEMT. In anderen Ausführungsformen der Erfindung kann ein Metall-Halbleiter-FET (MESFET) verwendet werden, bei dem der Gatefinger 54 direkt auf der Halbleiteroberfläche sitzt und einen Schottky-Kontakt bildet. In wiederum anderen Ausführungsformen der Erfindung kann ein Transistor mit hoher Elektronenmobilität (HEMT) verwendet werden, welcher einen Gatefingers 54 aufweist, der sich auf der Oberseite der Heterostruktur befindet. Die Gatespannung steuert die Bildung des zweidimensionalen Elektronengases (2DEG) in der Struktur. In weiteren Ausführungsformen der Erfindung können MOSFET- und HEMT zu einem MOSHEMT kombiniert werden.

Anhand der Figur 7 wird die Herstellung eines Dünnschichtwiderstandes 41 erläutert, welcher wie in Figur 2 gezeigt Teil des Gleichstrompfades 4 sein kann. Auch der Dünnschichtwiderstand 41 ist durch erste und zweite dielektrische Schichten 71 und 72 einerseits vom Substrat 5 elektrisch isoliert und andererseits vor Korrosion geschützt. Durch Material, Flächenausdehnung und Schichtdicke kann der Leiterquerschnitt und der elektrische Widerstand kontrolliert werden, sodass sich vorgebbare Widerstandswerte für den Gleichstrompfad 4 ergeben. Die elektrische Kontaktierung erfolgt wiederum durch Metallisierungen 56 und 52, welche einen größeren Querschnitt und/oder einen geringeren spezifischen Widerstand aufweisen können.

Anhand der Figur 9 wird ein erfindungsgemäßer integrierter Schaltkreis gemäß einem zweiten Ausführungsbeispiel erläutert. Gleiche Bestandteile der Erfindung sind mit gleichen Bezugszeichen versehen, sodass sich die nachfolgende Beschreibung auf die wesentlichen Unterschiede beschränkt. Wie im Vergleich zwischen Figur 9 und Figur 2 ersichtlich ist, unterscheiden sich die erste und zweite Ausführungsform im Wesentlichen durch die Lage des Gleichstrompfades. So sind die Widerstände 41 durch Brückenkontakte mit dem ersten Sourcekontakt verbunden, wohingegen in der in Figur 2 dargestellten ersten Ausführungsform eine direkte Verbindung innerhalb der durch das Substrat definierten Ebene zwischen dem ersten Sourcekontakt 12 und dem zweiten Sourcekontakt 22 besteht.

Anhand von Figur 10 wird eine dritte Ausführungsform des erfindungsgemäßen integrierten Schaltkreises gezeigt. Das Schaltbild des Integrierten Schaltkreises wird in Figur 19 dargestellt, wobei gleiche Bezugszeichen gleiche Merkmale bezeichnen. Die dritte Ausführungsform unterscheidet sich durch einen Kondensator 6, welcher zwischen dem ersten Sourcekontakt 12 und dem zweiten Gatekontakt 23 angeordnet ist. Dieser Kondensator ermöglicht eine Gleichstromtrennung zwischen dem ersten Feldeffekttransistor und dem zweiten Feldeffekttransistor, sodass eine Vorspannung an zumindest einem Bias-Kontakt angeschlossen werden kann, welcher über Brückenkontakte 55 mit dem zweiten Gateanschluss 23 verbunden ist. Die Ausführung der Kapazität 6 ist in Figur 8 im Schnitt näher erläutert.

Die Kapazität 6 ist durch ein erstes Dielektrikum 71 vom Substrat 5 getrennt. Die Kapazität 6 selbst enthält zwei Metallisierungsschichten 56a und 56b, welche durch ein zweites Dielektrikum 72 voneinander getrennt sind. Die beiden Metallisierungsschichten 56a und 56b bilden somit mit dem Dielektrikum 72 einen Plattenkondensator. Die Metallisierungsschicht 56b ist durch einen Brückenkontakt 55 mit dem ersten Sourcekontakt 12 verbunden.

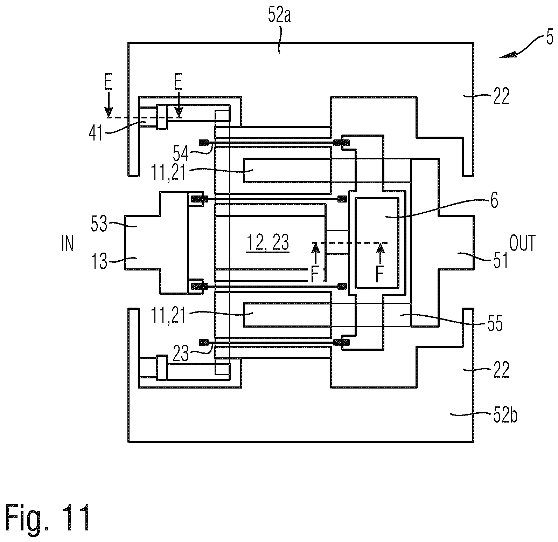

Anhand der Figur 11 wird ein viertes Ausführungsbeispiel des erfindungsgemäßen integrierten Schaltkreises näher erläutert. Die vierte Ausführungsform unterscheidet sich von der dritten Ausführungsform durch das Fehlen der Bias-Anschlüsse. Dafür existiert eine Gleichstromverbindung zwischen dem zweiten Gatekontakt und dem ersten Sourcekontakt über einen Widerstand, welcher parallel zu einem Kondensator 6 angeordnet ist.

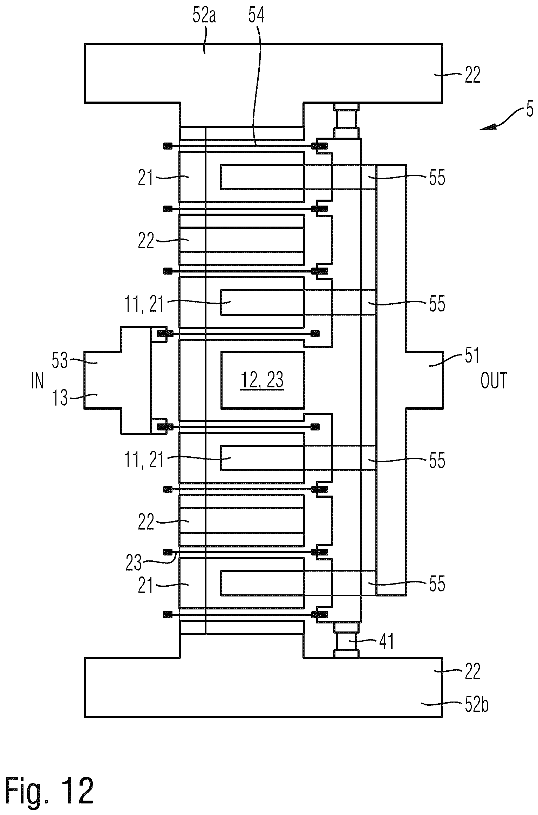

Anhand der Figur 12 wird ein fünftes Ausführungsbeispiel des erfindungsgemäßen integrierten Schaltkreises erläutert. Die fünfte Ausführungsform unterscheidet sich von der ersten Ausführungsform dadurch, dass die Anzahl und/oder die Fläche der zweiten Sourcekontakte 22 und der zweiten Drainkontakte 21 größer ist als die Anzahl bzw. die Fläche der ersten Sourcekontakte 12 und der ersten Drainkontakte 11. Hierdurch kann die Stromtragfähigkeit bzw. die elektrische Leistung des zweiten Feldeffekttransistors 2 verschieden, insbesondere größer sein als die Leistung des ersten Feldeffekttransistors 1. Da der zweite Feldeffekttransistor 2 einen größeren Anteil zur Ausgangsleistung beiträgt, kann die Ausgangsleistung des integrierten Schaltkreises insgesamt vergrößert sein.

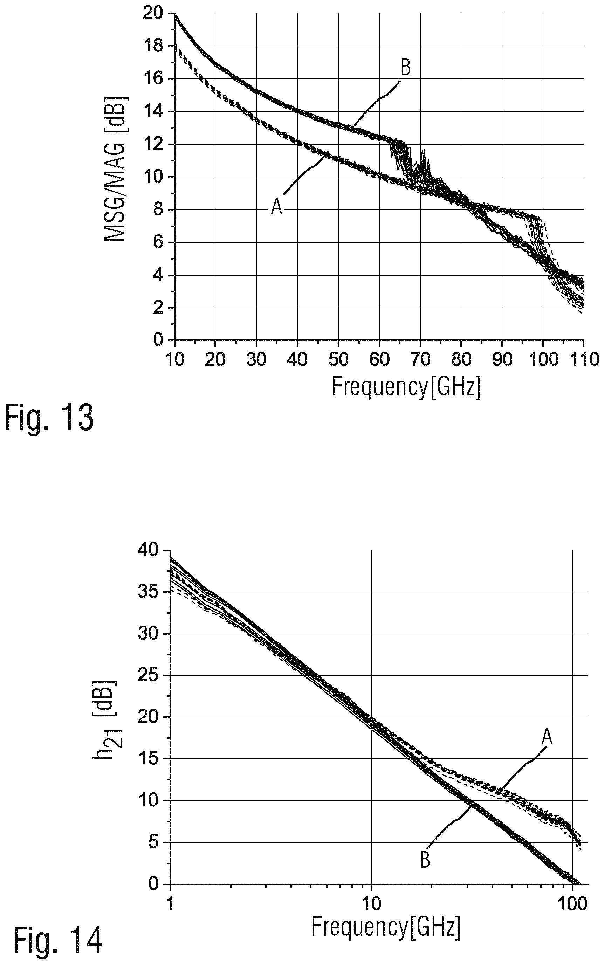

Anhand der Figuren 13 und 14 wird die Leistungsfähigkeit des erfindungsgemäßen integrierten Schaltkreises mit der Leistung eines einzelnen Feldeffekttransistors in Common-Source-Topologie verglichen. Dabei zeigt Figur 13 die maximale stabile Verstärkung und die maximale verfügbare Verstärkung in dB.

Die Verstärkung eines Transistors, die über die Frequenz aufgetragen wird, weist zwei Bereiche auf:
1. Die maximale stabile Verstärkung (MSG), bei der der FET bedingt stabil ist. In diesem Bereich sinkt die Verstärkung mit zunehmender Frequenz um ca. 10dB pro Dekade.
2. Ab einer bestimmten Frequenz wandelt sich die MSG in die maximal verfügbare Verstärkung (MAG), wobei der FET unbedingt stabil ist. In dieser Region sinkt der Gewinn jedoch um rund 20dB pro Dekade.

Dabei ist aus Kurve A ersichtlich, dass der Übergang zwischen MSG und MAG für den erfindungsgemäßen integrierten Schaltkreis bei einer Arbeitsfrequenz von etwa 100 GHz liegt, wohingegen ein einzelner, an sich bekannter Feldeffekttransistor den Übergang bereits bei einer Grenzfrequenz von 65 GHz zeigt, vgl. Kurve B. Damit zeigt das erfindungsgemäße Bauelement nach Kurve A zwischen 80 und 100 GHz eine höhere Verstärkung als der Feldeffekttransistor in Common-Source-Topologie.

Figur 14 zeigt die Stromverstärkung in dB gegen die Frequenz. Dabei wird ein Sinussignal am Eingang angelegt und der Ausgang kurzgeschlossen. Als Cut-off-Frequenz wird derjenige Wert angesehen, bei welchem die Stromverstärkung eins ist bzw. die dargestellten Messkurven die x-Achse schneiden. Wiederum zeigt die Kurve B die Messwerte eines einzigen Feldeffekttransistors, bei welchem die Grenzfrequenz etwa 100 GHz beträgt. Wie aus Kurve A ersichtlich ist, ermöglicht der erfindungsgemäße integrierte Schaltkreis eine wesentlich höhere Cut-off-Frequenz, welche im dargestellten Ausführungsbeisiel in etwa verdoppelt ist.

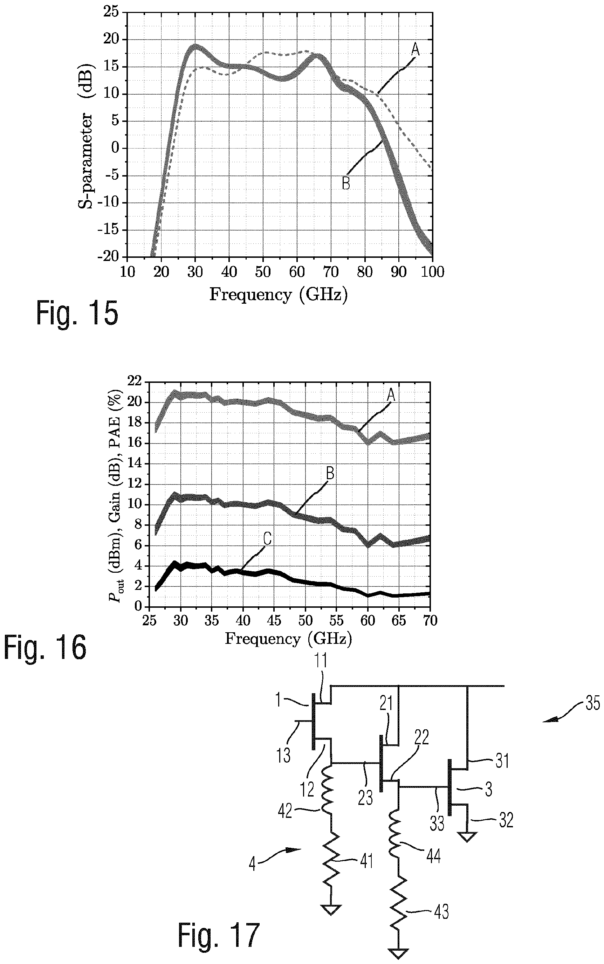

Figur 15 zeigt das Kleinsignalverhalten eines erfindungsgemäßen Schaltkreises gemäß der in Figur 10 dargestellten dritten Ausführungsform über der Frequenz. Dargestellt ist der Streuparameter bzw. S-Parameter zwischen dem Ausgang und dem Eingang, welcher das elektrische Verhalten der Schaltung unter stationären Eingangsignalen beschreibt. Dargestellt sind in Kurve B Messwerte für 11 nominell gleiche Schaltungen. Kurve A zeigt das berechnete Verhalten. Die aus der Figur ersichtlichen geringen Abweichungen der Schaltungen zeigen, dass nominell gleiche Schaltungen auch nahezu identisches Verhalten zeigen und daher reproduzierbar herstellbar sind.

Der erfindungsgemäße integrierte Schaltkreis 35 liefert mehr als 13 dB Kleinsignalverstärkung (S₂₁) über einen Frequenzbereich von etwa 26 GHz bis etwa 71 GHz. Dies entspricht einer Betriebsbandbreite von 92,8% bzw. 1,45 Oktaven. Figur 15 zeigt, dass der erfindungsgemäße integrierte Schaltkreis 35 in der Lage ist, eine vollständige Abdeckung von mehreren Millimeterwellenbändern zu ermöglichen, einschließlich des Ka-Bandes (26-40 GHz), des Q-Bandes (33-50 GHz), des U-Bandes (40-60 GHz) und nahezu des gesamten V-Bandes (50-75 GHz).

Figur 16 zeigt das Großsignalverhalten eines erfindungsgemäßen Schaltkreises gemäß der in Figur 10 dargestellten dritten Ausführungsform über der Frequenz. Dargestellt ist in Kurve A die Ausgangsleistung, in Kurve B die Verstärkung und in Kurve C der Leistungswirkungsgrad. Die in Figur 16 gezeigten Messwerte wurden mit einer konstanten Amplitude des Eingangssignals von 10 dBm ermittelt. Dargestellt sind wiederum Messwerte für 11 nominell gleiche Schaltungen. Die aus Figur 16 ersichtlichen, geringen Abweichungen der einzelnen Schaltungen voneinander zeigen, dass nominell gleiche Schaltungen auch nahezu identisches Verhalten zeigen und daher reproduzierbar herstellbar sind.

Aus Figur 16 ist ersichtlich, dass der erfindungsgemäße integrierte Schaltkreis 35 eine Ausgangsleistung von 16 dBm bis 21,2 dBm über einen Frequenzbereich von etwa 26 GHz bis etwa 70 GHz liefert, mit einem durchschnittlichen Wert von 19 dBm. Der jeweilige Leistungswirkungsgrad, d.h. das Verhältnis von der abgegebenen zur zugeführten Leistung, liegt zwischen etwa 1 % und etwa 4,5 %.

Figur 17 zeigt ein Schaltbild des integrierten Schaltkreises gemäß einer sechsten Ausführungsform. Gleiche Bestandteile der Erfindung sind mit gleichen Bezugszeichen versehen. Der Schaltkreis enthält zumindest einen ersten Feldeffekttransistor 1 und einen zweiten Feldeffekttransistor 2 sowie einen dritten Feldeffekttransistor 3. Der erste Feldeffekttransistor 1 weist einen ersten Drainkontakt 11 sowie einen ersten Sourcekontakt 12 auf. Zwischen Source und Drain befindet sich ein Kanal, dessen Leitfähigkeit in Abhängigkeit einer Gatespannung kontrolliert werden kann, welche am ersten Gatekontakt 13 angelegt werden kann.

Der zweite Feldeffekttransistor 2 weist einen zweiten Drainkontakt 21 sowie einen zweiten Sourcekontakt 22 auf. Weiterhin weist der zweite Feldeffekttransistor 2 in an sich bekannter Weise einen zweiten Gatekontakt 23 auf.

Der dritte Feldeffekttransistor 3 weist einen dritten Drainkontakt 31 sowie einen dritten Sourcekontakt 32 auf. Weiterhin weist der dritte Feldeffekttransistor 3 in an sich bekannter Weise einen dritten Gatekontakt 33 auf.

Der dritte Sourcekontakt 32 ist mit einem Referenzpotenzial verbunden, beispielsweise einem Erdpotenzial bzw. einem Massepotenzial. Der dritte Gatekontakt 33 ist mit dem zweiten Sourcekontakt 22 verbunden. Der zweite Gatekontakt 23 ist mit dem ersten Sourcekontakt 12 verbunden. Der erste Gatekontakt 13 bildet den Eingang der Verstärkerschaltung 35. Die drei Drainkontakte 11, 21 und 31 bilden den Ausgang der Verstärkerschaltung.

Bei Anlegen einer Eingangsspannung an den ersten Gatekontakt 13 wird der Kanal zwischen dem ersten Sourcekontakt 12 und dem ersten Drainkontakt 11 leitend, sodass eine Gatespannung am zweiten Gatekontakt 23 anliegt, welche den Kanal zwischen dem zweiten Sourcekontakt 22 und dem zweiten Drainkontakt 21 ebenfalls leitfähig schaltet. Dies führt dazu, dass auch am dritten Gatekontakt 33 eine Gatespannung anliegt, so dass auch der Kanal zwischen dem dritten Sourcekontakt 32 und dem dritten Drainkontakt 31 leitfähig schaltet.

Beim Schalten der Gatespannung unter die Schaltschwelle am ersten Gatekontakt 13 sperrt der Kanal zwischen dem ersten Sourcekontakt 12 und dem ersten Drainkontakt 11. Da der zweite Gatekontakt 23 im Wesentlichen stromlos ist, wird die dort gesammelte Ladung über den Widerstand 41 und die seriell verschaltete Induktivität 42 des Gleichstrompfades 4 abgeleitet. Der zumindest eine Widerstand 41 und/oder die zumindest eine Induktivität 42 vermeiden, dass ein hochfrequentes Nutzsignal über den Gleichstrompfad 4 zum Massepotenzial kurzgeschlossen wird. In gleicher Weise sperrt der Kanal zwischen dem zweiten Sourcekontakt 22 und dem zweiten Drainkontakt 21. Da der dritte Gatekontakt 33 im Wesentlichen stromlos ist, wird die dort gesammelte Ladung über den Widerstand 43 und die seriell verschaltete Induktivität 44 des Gleichstrompfades 4 abgeleitet. Der zumindest eine Widerstand 43 und/oder die zumindest eine Induktivität 44 vermeiden, dass ein hochfrequentes Nutzsignal über den Gleichstrompfad 4 zum Massepotenzial kurzgeschlossen wird.

In gleicher Weise, wie anhand der Figuren 1 und 17 für einen 2-stufigen bzw. 3-stufigen Verstärker erläutert, können auch Verstärker mit einer noch höheren Anzahl an Feldeffekttransistoren bzw. Verstärkerstufen realisiert werden.

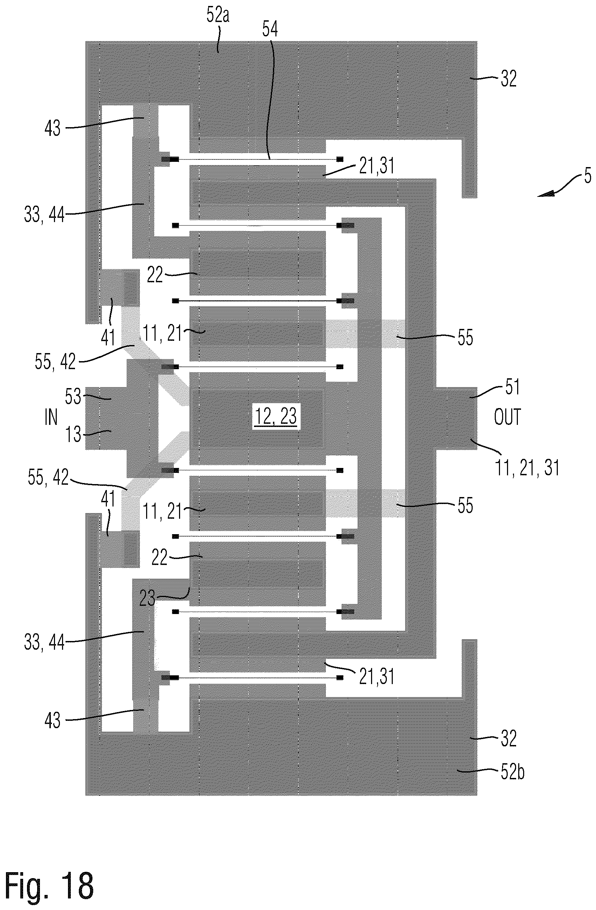

Figur 18 zeigt die Aufsicht auf einen erfindungsgemäßen Schaltkreis gemäß der sechsten Ausführungsform. Gleiche Bestandteile der Erfindung sind mit gleichen Bezugszeichen versehen, so dass sich die nachstehende Beschreibung auf die wesentlichen Unterschiede beschränkt.

Die sechste Ausführungsform unterscheidet sich von den vorstehend beschriebenen ersten bis fünften Ausführungsformen dadurch, dass die Anzahl der Feldeffekttransistoren und damit die Fläche der Sourcekontakte, der Gatekontakte und der Drainkontakte erhöht ist, wie in Zusammenhang mit Figur 17 beschrieben. Dies führt zu einer weiter sinkenden Eingangskapazität, so dass die Arbeitsfrequenz und/oder die Bandbreite weiter erhöht sein kann.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Ausführungsformen definieren, so dient diese Bezeichnung der Unterscheidung zweier gleichartiger Ausführungsformen, ohne eine Rangfolge festzulegen.

## Patentansprüche

1. Integrierter Schaltkreis (35) mit zumindest einem ersten Feldeffekttransistor (1), welcher zumindest einen ersten Sourcekontakt (12) und zumindest einen ersten Drainkontakt (11) und zumindest einen ersten Gatekontakt (13) aufweist und
mit zumindest einem zweiten Feldeffekttransistor (2), welcher zumindest einen zweiten Sourcekontakt (22) und zumindest einen zweiten Drainkontakt (21) und zumindest einen zweiten Gatekontakt (23) aufweist, wobei der erste Drainkontakt (11) mit dem zweiten Drainkontakt (21) verbunden ist und
der erste Sourcekontakt (12) mit dem zweiten Gatekontakt (23) verbunden ist,
**dadurch gekennzeichnet, dass**
der erste Sourcekontakt (12), der erste Drainkontakt (11), der erste Gatekontakt (13), der zweite Sourcekontakt (22), der zweite Drainkontakt (21) und der zweite Gatekontakt (23) als strukturierte Metallisierung auf einem Substrat (5) ausgebildet sind und
der erste und zweite Drainkontakt (11, 21) den selben Flächenbereich (51) auf dem Substrat (5) belegen.

2. Integrierter Schaltkreis nach Anspruch 1, **dadurch gekennzeichnet, dass** das Substrat (5) Al₂O₃ und/oder SiC und/oder Si und/oder ein Gruppe-III-Nitrid enthält oder daraus besteht.

3. Integrierter Schaltkreis nach Anspruch 1 oder 2, **dadurch gekennzeichnet, dass** der erste und zweite Drainkontakt (11, 21) als Ausgang verwendbar ist und der erste Gatekontakt (13) als Eingang verwendbar ist.

4. Integrierter Schaltkreis nach einem der Ansprüche 1 bis 3, **dadurch gekennzeichnet, dass** der erste und zweite Drainkontakt (11, 21) einen gemeinsamen Flächenbereich auf dem Substrat (5) aufweisen.

5. Integrierter Schaltkreis nach einem der Ansprüche 1 bis 4, **dadurch gekennzeichnet, dass** weiterhin ein Gleichstrompfad (4) vom zweiten Gatekontakt (23) zu einem Referenzpotential vorhanden ist.

6. Integrierter Schaltkreis nach einem der Ansprüche 1 bis 5, dass der erste und zweite Drainkontakt (11, 21) jeweils zwei Flächenbereiche (51a, 51b) auf dem Substrat (5) aufweisen, welche an gegenüberliegenden Seiten des ersten Sourcekontaktes (12) angeordnet sind.

7. Integrierter Schaltkreis nach einem der Ansprüche 1 bis 6, **dadurch gekennzeichnet, dass** an der dem ersten Sourcekontakt (12) abgewandten Seite der ersten und zweiten Drainkontakte (11, 21) jeweils ein zweiter Sourcekontakt (22) angeordnet ist.

8. Integrierter Schaltkreis nach einem der Ansprüche 1 bis 7, **dadurch gekennzeichnet, dass** der Gleichstrompfad (4) zumindest einen Widerstand (41) und/oder zumindest eine Induktivität (42) enthält.

9. Integrierter Schaltkreis nach einem der Ansprüche 1 bis 8, weiterhin enthaltend eine Kapazität (6), welche mit dem ersten Sourcekontakt (12) und dem zweiten Gatekontakt (23) verbunden ist.

10. Integrierter Schaltkreis nach einem der Ansprüche 1 bis 9, **dadurch gekennzeichnet, dass** die Anzahl und/oder die Fläche der Flächenbereiche der zweiten Drainkontakte (21) und/oder der zweiten Sourcekontakte (22) unterschiedlich, insbesondere größer ist als die Anzahl und/oder die Fläche des ersten und zweiten Drainkontakts (11, 21) und/oder des ersten Sourcekontakts (12) und des zweiten Gatekontakts (23).

11. Integrierter Schaltkreis nach einem der Ansprüche 1 bis 10, **dadurch gekennzeichnet, dass** das Substrat (5) zumindest ein Gruppe-III-Nitrid oder einen III-V-Verbindungshalbleiter oder einen Halbleiter der Gruppe IV oder einen II-VI-Verbindungshalbleiter enthält oder daraus besteht und/oder
dass im Substrat (5) ein zweidimensionales Elektronengas ausbildbar ist.

12. Integrierter Schaltkreis nach einem der Ansprüche 1 bis 11, **dadurch gekennzeichnet, dass** dieser eine Grenzfrequenz von mehr als 20 GHz oder mehr als 40 GHz oder mehr als 60 GHz oder mehr als 100 GHz aufweist oder dass dieser eine Grenzfrequenz aufweist, welche um mehr als 10% oder mehr als 20% der mehr als 30% höher ist als die Grenzfrequenz eines einzelnen FET in einer Common-Source-Topologie, welcher mit dem gleichen Herstellungsprozess hergestellt wurde.

13. Elektronisches Gerät mit zumindest einem integrierten Schaltkreis nach einem der Ansprüche 1 bis 12.
